# EUROPEAN PATENT APPLICATION

(11) **EP 4 633 038 A1**
(43) Date of publication of application: **15.10.2025**
(21) Application number: 23900298.3
(22) Date of filing: 05.10.2023
(51) Int. Cl.: H03F 1/56, H01J 49/02, H03F 3/30

(54) **AMPLIFICATION CIRCUIT AND MASS SPECTROSCOPE PROVIDED WITH SAME**

(30) Priority: 09.12.2022 JP 2022196887
(71) Applicant: HITACHI HIGH-TECH CORPORATION, Tokyo 105-6409 (JP)
(72) Inventor: OBARA, Takuya, Tokyo 100-8280 (JP); NISHIMOTO, Takuma, Tokyo 100-8280 (JP); FURUYA, Isao, Tokyo 105-6409 (JP)
(74) Representative: Mewburn Ellis LLP
(86) International application number: PCT/JP2023/036423
(87) International publication number: WO 2024/122175

(57) **Abstract**

An amplifier circuit 101 includes: a first current source circuit 113 configured to output a predetermined current amount to a first interconnect L1; a voltage amplifier circuit 110 configured to amplify a voltage of an input signal; a first level shift circuit 111 connected between the first interconnect L1 and an output of the voltage amplifier circuit 110 and configured to shift a voltage of a signal output from the voltage amplifier circuit 110; a first voltage follower 117 connected to the first interconnect L1 and configured to amplify a signal in the first interconnect L1; and a first capacitor 210 connected between the first interconnect L1 and the output of the voltage amplifier circuit 110.

## Description

### Technical Field

The present invention relates to an amplifier circuit and a mass spectrometer including the same, and more particularly to a technique for achieving both high-frequency operation and high power of the amplifier circuit and the mass spectrometer.

### Background Art

A technique for achieving a high-frequency operation of an amplifier circuit is described in, for example, PTL 1. That is, PTL 1 discloses an amplifier circuit in which a plurality of amplifiers each including a common-source transistor, a common-drain transistor, and a feedback resistor are connected in multiple stages (cascade connection) in order to achieve both high gain and wide band.

### Citation List

### Patent Literature

PTL 1: JP2004-96308A

### Summary of Invention

### Technical Problem

As illustrated in PTL 1, when the amplifiers are provided in multiple stages, there is a problem that an occupied area (hereinafter, also simply referred to as a size) of the amplifier circuit increases. In addition, an amplifier for achieving both high gain and wide band generally has a problem of high power consumption.

An object of the invention is to provide an amplifier circuit capable of achieving both high-frequency operation and high power while reducing heat generation and an increase in size, and a mass spectrometer including the amplifier circuit.

Other objects and novel features of the invention will become apparent from description of the present description and the accompanying drawings.

### Solution to Problem

An outline of a representative one among embodiments disclosed in the present application will be briefly described as follows.

That is, an amplifier circuit according to one embodiment includes: a first current source circuit configured to output a predetermined current amount to a first interconnect; a voltage amplifier circuit configured to amplify a voltage of an input signal; a first level shift circuit connected between the first interconnect and an output of the voltage amplifier circuit and configured to shift a voltage of a signal output from the voltage amplifier circuit; a first voltage follower connected to the first interconnect and configured to amplify a signal in the first interconnect; and a first capacitor connected between the first interconnect and the output of the voltage amplifier circuit.

In another embodiment, a mass spectrometer is provided. The mass spectrometer according to the other embodiment includes an amplifier circuit having suitable characteristics as an amplifier circuit used therein.

### Advantageous Effects of Invention

To briefly describe the effects obtained by typical embodiments among the inventions disclosed in the present application, it is possible to provide an amplifier circuit capable of achieving a high-frequency operation and high power while reducing heat generation and an increase in size, and a mass spectrometer including the amplifier circuit.

### Brief Description of Drawings

[FIG. 1] FIG. 1 is a circuit diagram illustrating a configuration of an amplifier circuit according to Embodiment 1.
[FIG. 2] FIG. 2 is a circuit diagram illustrating a configuration of an amplifier circuit according to a comparative example.
[FIG. 3] (A) to (C) of FIG. 3 are waveform diagrams illustrating an operation of the amplifier circuit according to the comparative example.
[FIG. 4] (A) to (C) of FIG. 4 are waveform diagrams illustrating an effect of a capacitor according to Embodiment 1.
[FIG. 5] (A) and (B) of FIG. 5 are waveform diagrams illustrating output signals of the amplifier circuit according to Embodiment 1 and the amplifier circuit according to the comparative example.
[FIG. 6] (A) and (B) of FIG. 6 are circuit diagrams illustrating an amplifier circuit according to Embodiment 2.
[FIG. 7] FIG. 7 is a block diagram illustrating a configuration of a mass spectrometer according to Embodiment 3.
[FIG. 8] FIG. 8 is a circuit diagram illustrating a configuration of an RF signal generation unit according to Embodiment 3.
[FIG. 9] FIG. 9 is a diagram illustrating formulas according to the embodiment.

### Description of Embodiments

Embodiments will be described with reference to the drawings. The embodiments described below do not limit the invention according to the range of claims, and it is not necessary that all of the elements and combinations described in the embodiments are essential to the solution of the invention.

### (Embodiment 1)

### <Overall Configuration of Amplifier Circuit>

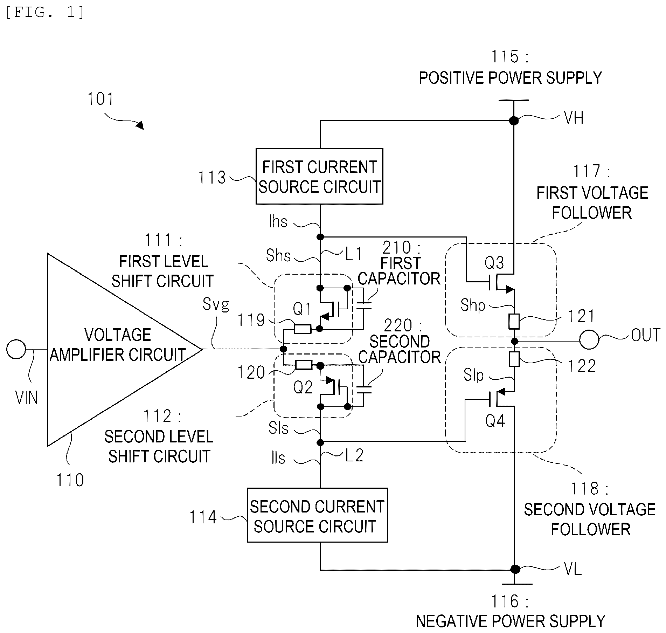

FIG. 1 is a circuit diagram illustrating a configuration of an amplifier circuit according to Embodiment 1. In FIG. 1, 101 denotes the amplifier circuit.

The amplifier circuit 101 includes a voltage amplifier circuit 110, a first level shift circuit 111, a first capacitor 210, a second level shift circuit 112, a second capacitor 220, a first current source circuit 113, a second current source circuit 114, a positive power supply 115, a negative power supply 116, a first voltage follower 117, and a second voltage follower 118.

An output terminal of the voltage amplifier circuit 110 is connected to the first level shift circuit 111 and the second level shift circuit 112. The first current source circuit 113 is connected to the positive power supply 115, and the first current source circuit 113 and the first level shift circuit 111 are connected by a first interconnect L1. The second current source circuit 114 is connected to the negative power supply 116, and the second current source circuit 114 and the second level shift circuit 112 are connected by a second interconnect L2. That is, the first current source circuit 113 and the first level shift circuit 111 are connected in series between the output terminal of the voltage amplifier circuit 110 and the positive power supply 115, and the second current source circuit 114 and the second level shift circuit 112 are connected in series between the output terminal of the voltage amplifier circuit 110 and the negative power supply 116.

The first voltage follower 117 is connected between the positive power supply 115 and an output terminal of the amplifier circuit 101, and an input terminal of the first voltage follower 117 is connected to the first interconnect L1. The second voltage follower 118 is connected between the negative power supply 116 and the output terminal of the amplifier circuit 101, and an input terminal of the second voltage follower 118 is connected to the second interconnect L2. That is, the first voltage follower 117 and the second voltage follower 118 are connected in series between the positive power supply 115 and the negative power supply 116.

### <Configuration of Circuits Constituting Amplifier Circuit>

Next, circuits constituting the amplifier circuit 101 will be described with reference to FIG. 1.

The voltage amplifier circuit 110 amplifies a voltage amplitude of an input signal VIN supplied to an input terminal, and outputs an output signal Svg having an amplified voltage amplitude from the output terminal.

The first level shift circuit 111 includes a load resistor 119 and an N-channel MOS (field-effect) transistor (hereinafter also referred to as an N-type transistor) Q1. The load resistor 119 is connected between a source of the N-type transistor Q1 and the output terminal of the voltage amplifier circuit 110, and a drain and a gate of the N-type transistor Q1 are connected to one end of the first interconnect L1. The N-type transistor Q1 functions as a diode (voltage element) by connecting the drain and the gate.

One terminal of the first capacitor 210 is connected to the source of the N-type transistor Q1, and the other terminal is connected to the drain and gate of the N-type transistor Q1.

The second level shift circuit 112 includes a load resistor 120 and a P-channel MOS transistor (hereinafter also referred to as a P-type transistor) Q2. The load resistor 120 is connected between a source of the P-type transistor Q2 and the output terminal of the voltage amplifier circuit 110, and a drain and a gate of the P-type transistor Q2 are connected to one end of the second interconnect L2. The P-type transistor Q2 also functions as a diode (voltage element) by connecting the drain and the gate.

One terminal of the second capacitor 220 is connected to the source of the P-type transistor Q2, and the other terminal is connected to the drain and gate of the P-type transistor Q2.

The first level shift circuit 111 receives the output signal Svg from the voltage amplifier circuit 110 as an input, and outputs a positive electrode side level shift signal Shs to the first interconnect L1. That is, the first level shift circuit 111 outputs the level shift signal Shs obtained by shifting the output signal Svg toward a positive power supply 115 side by an amount of voltage defined by a diode configured with the N-type transistor Q1.

The second level shift circuit 112 receives the output signal Svg from the voltage amplifier circuit 110 as an input, and outputs a negative electrode side level shift signal Sls to the second interconnect L2. That is, the second level shift circuit 112 outputs the level shift signal Sls obtained by shifting the output signal Svg toward a negative power supply 116 side by an amount of voltage defined by a diode configured with the P-type transistor Q2.

Since the first capacitor 210 and the second capacitor 220 will be described later, the description thereof will be omitted here.

The first current source circuit 113 is connected to the other end of the first interconnect L1 and outputs a drive current Ihs having a predetermined value (current amount) to the first level shift circuit 111 via the first interconnect L1. Similarly, the second current source circuit 114 is connected to the other end of the second interconnect L2 and outputs a drive current Ils having a predetermined value to the second level shift circuit 112 via the second interconnect L2.

In Embodiment 1, the first voltage follower 117 is implemented by a source follower circuit. That is, the first voltage follower 117 includes an N-type transistor Q3 with drain ground connection and a load resistor 121. The N-type transistor Q3 has a drain connected to the positive power supply 115, a source connected to the output terminal of the amplifier circuit 101 via the load resistor 121, and a gate connected to the first interconnect L1.

In Embodiment 1, the second voltage follower 118 is also implemented by a source follower circuit. That is, the second voltage follower 118 includes a P-type transistor Q4 with drain ground connection and a load resistor 122. The P-type transistor Q4 has a drain connected to the negative power supply 116, a source connected to the output terminal of the amplifier circuit 101 via the load resistor 122, and a gate connected to the second interconnect L2.

The first voltage follower 117 receives the positive electrode side level shift signal Shs on the first interconnect L1 using a gate of the N-type transistor Q3 as an input terminal, and uses a source of the N-type transistor Q3 as an output terminal and outputs a positive electrode side output signal Shp that corresponds to the positive electrode side level shift signal Shs. In contrast, the second voltage follower 118 receives the negative electrode side level shift signal Sls on the second interconnect L2 using a gate of the P-type transistor Q4 as an input terminal, and uses a source of the P-type transistor Q4 as an output terminal and outputs a negative electrode side output signal Slp that corresponds to the negative electrode side level shift signal Sls.

The output signal Shp and the output signal Slp are combined (added) via the load resistors 121 and 122 to be an output signal OUT (= Shp + Slp) of the amplifier circuit 101.

The amplifier circuit 101 can be considered to be functionally divided into a voltage amplification stage, a level shift stage, and an output stage.

Here, the input stage corresponds to a portion including the voltage amplifier circuit 110. The voltage amplifier circuit 110 has a voltage amplification factor that is set in advance, for example, at a design stage. The input stage amplifies a voltage of the input signal VIN according to the preset voltage amplification factor and outputs the amplified output signal Svg.

The level shift stage corresponds to a portion including the first level shift circuit 111 on a positive electrode side, the first current source circuit 113, the second level shift circuit 112 on a negative electrode side, and the second current source circuit 114.

The first level shift circuit 111 receives the output signal Svg obtained by the amplification as an input, and outputs the positive electrode side level shift signal Shs. Here, the level shift signal Shs has a value obtained by level-shifting the output signal Svg to the positive electrode side by a voltage amount determined by a current amount flowing through the N-type transistor Q1 in the drive current Ihs output from the first current source circuit 113 to the first interconnect L1. That is, when a current flows through the diode configured with the N-type transistor Q1, the output signal Svg is at a positive electrode side level by a voltage amount generated by the diode.

Similarly, the second level shift circuit 112 receives the output signal Svg obtained by the amplification as an input, and outputs the negative electrode side level shift signal Sls. Here, the level shift signal Sls has a value obtained by level-shifting the output signal Svg to the negative electrode side by a voltage amount determined by a current amount flowing through the P-type transistor Q2 in the drive current Ils output from the second current source circuit 114 to the second interconnect L2. That is, when a current flows through the diode configured with the P-type transistor Q2, the output signal Svg is at a negative electrode side level by a voltage amount generated by the diode.

The first capacitor 210 and the second capacitor 220 connected to the first level shift circuit 111 and the second level shift circuit 112 have a role of charging parasitic capacitance that is parasitic on the first interconnect L1 and the second interconnect L2. Examples of the capacitance that is parasitic on the first interconnect L1 include parasitic capacitance of a circuit connected to the second interconnect, for example, the input terminal of the first voltage follower 117. Examples of the parasitic capacitance of the input terminal of the first voltage follower 117 include gate capacitance of the N-type transistor Q3. The capacitance that is parasitic on the second interconnect L2 is also similar as the capacitance that is parasitic on the first interconnect L1, and includes, for example, parasitic capacitance of a circuit connected to the interconnect L2, for example, the input terminal of the second voltage follower 118. Examples of the parasitic capacitance of the input terminal of the second voltage follower 118 include gate capacitance of the P-type transistor Q4.

In the present description, charging of the capacitance means both discharging and charging unless otherwise specified.

The output stage corresponds to a portion including the first voltage follower 117 on the positive electrode side and the second voltage follower 118 on the negative electrode side. The voltage follower includes a MOS transistor and a load resistor. The first voltage follower 117 receives the positive electrode side level shift signal Shs as an input, and outputs the output signal Shp whose voltage is reduced by a threshold value of the N-type transistor Q3. At this time, when a voltage of the positive electrode side level shift signal Shs is a voltage exceeding the threshold value of the N-type transistor Q3, the N-type transistor Q3 is turned ON, and a current on the positive electrode side flows. That is, a current corresponding to the voltage of the level shift signal Shs flows from the positive power supply 115 to the output terminal of the amplifier circuit 101 via the N-type transistor Q3.

The second voltage follower 118 is similar to the first voltage follower 117. That is, the second voltage follower 118 receives the negative electrode side level shift signal Sls as an input, and outputs the output signal Slp whose voltage is reduced by a threshold value of the P-type transistor Q4. At this time, when a voltage of the level shift signal Sls is a voltage exceeding the threshold value of the P-type transistor Q4, the P-type transistor Q4 is turned ON, and a current on the negative electrode side flows. That is, a current corresponding to the voltage of the level shift signal Sls flows from the negative power supply 116 to the output terminal of the amplifier circuit 101 via the P-type transistor **Q4.**

The voltage of the input signal VIN changes, for example, alternately between the positive electrode side and the negative electrode side with respect to a ground voltage, so that an operation of flowing a current on the positive electrode side and an operation of flowing a current on the negative electrode side are alternately performed, and the output stage achieves a push-pull operation.

In FIG. 1, a case where the source follower circuit is used as the voltage follower is described, but the invention is not limited thereto. For example, when a bipolar transistor is used instead of the MOS transistor, the first and second voltage followers 117 and 118 are implemented by emitter follower circuits.

### <First and Second Capacitors>

Next, effects of the first capacitor 210 and the second capacitor 220 connected to the level shift circuits 111 and 112 will be described. Since the effect of the second capacitor 220 is the same as the effect of the first capacitor 210, only the first capacitor 210 will be described here.

To facilitate understanding, first, an amplifier circuit in which the first and second capacitors 210 and 220 are not connected to the first and second level shift circuits will be described as a comparative example.

### <Comparative Example>

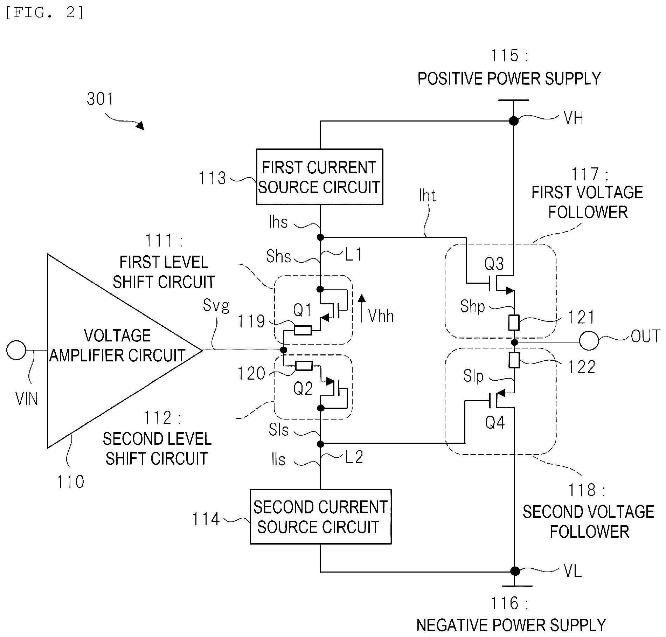

FIG. 2 is a circuit diagram illustrating a configuration of an amplifier circuit according to the comparative example. An amplifier circuit 301 illustrated in the figure is similar to the amplifier circuit 101 illustrated in FIG. 1. A main difference is that the amplifier circuit 301 illustrated in FIG. 2 does not include the first and second capacitors 210 and 220 illustrated in FIG. 1. In FIG. 2, Ihs indicates a drive current having a predetermined value output by the first current source circuit 113 in order to drive the N-type transistor Q1 of the first level shift circuit 111, and Vhh indicates a level shift voltage by the first level shift circuit 111.

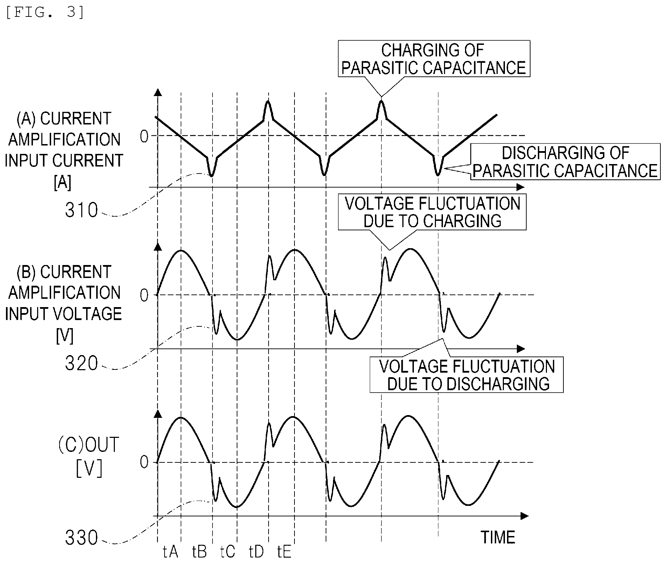

FIG. 3 is a waveform diagram illustrating an operation of the amplifier circuit according to the comparative example. Here, (A) of FIG. 3 illustrates a current waveform of an input signal of the first voltage follower 117, (B) of FIG. 3 illustrates a voltage waveform of the input signal of the first voltage follower 117, and (C) of FIG. 3 illustrates a waveform of an output signal OUT of the amplifier circuit 301. In (A) to (C) of FIG. 3, a broken line extending horizontally and denoted by reference sign 0 indicates a ground voltage (0 V) or a reference current (0 A).

In a section tA, an input voltage of the first voltage follower 117 starts to increase from 0 V as illustrated in (B) of FIG. 3. Then, as illustrated in (A) of FIG. 3, an input current flows through the first voltage follower 117. When a value of the input voltage of the first voltage follower 117 becomes maximum (when transitioning from the section tA to a section tB), that is, when a change amount of the input voltage becomes 0, the input current flowing through the first voltage follower 117 becomes 0 A.

In the section tB, as illustrated in (B) of FIG. 3, the input voltage starts to decrease from a maximum value. Then, as illustrated in (A) of FIG. 3, a negative current starts to flow. When the value of the input voltage becomes 0 V (when transitioning from the section tB to a section tC), that is, when a change amount of the input voltage becomes maximum, a value of a flowing input current becomes maximum. When the section tB transitions to the section tC, the input voltage is switched from a positive voltage to a negative voltage as illustrated in (B) of FIG. **3****.** At this time, parasitic capacitance associated with the input terminal of the first voltage follower 117 is discharged, and a large current Iht (FIG. 2) transiently flows as indicated by reference sign 310. The transient large current Iht for discharging the parasitic capacitance is supplied from the first current source circuit 113.

However, since the first current source circuit 113 outputs the drive current Ihs to the first level shift circuit 111, when the transient large current Iht flows through the first voltage follower 117, a value of the drive current flowing through the first level shift circuit 111 fluctuates. When the supplied drive current fluctuates, the level shift voltage Vhh of the first level shift circuit 111 fluctuates.

The positive electrode side level shift signal Shs output from the first level shift circuit 111 corresponds to a signal obtained by level-shifting the output signal Svg of the voltage amplifier circuit 110 by the level shift voltage Vhh. As a result, the level shift signal Shs also fluctuates in a similar manner.

Since the level shift signal Shs is the input signal of the first voltage follower 117, this input signal also becomes a distorted signal due to the transient large current Iht, as indicated by reference sign 320 in (B) of FIG. **3****.** Further, since the waveform of the output signal of the first voltage follower 117 is obtained by dropping a voltage of the input signal of the first voltage follower 117 by a threshold value of the N-type transistor Q3, the output signal OUT of the amplifier circuit 301 has a distorted waveform as indicated by reference sign 330 in (C) of FIG. 3.

### <Effects of First and Second Capacitors>

Next, a case where the first capacitor 210 and the second capacitor 220 are provided as illustrated in FIG. 1 will be described.

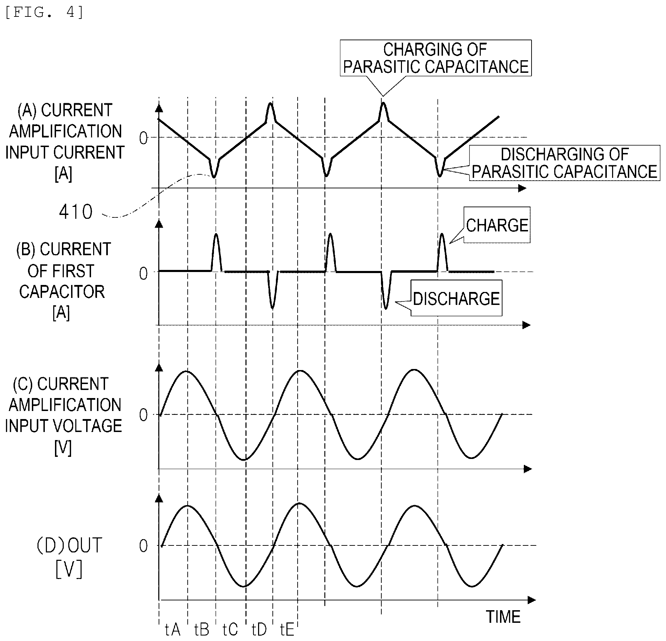

FIG. 4 is a waveform diagram illustrating an effect of the capacitor according to Embodiment 1. In the figure, a current flowing through the first capacitor 210, an input voltage of the first voltage follower 117, and an input current of the first voltage follower 117 are simply illustrated. Here, (A) of FIG. 4 illustrates a waveform of the input current of the first voltage follower 117, and (B) of FIG. 4 illustrates a waveform of a current flowing through the first capacitor 210. (C) of FIG. 4 illustrates a waveform of the input voltage of the first voltage follower 117, and (D) of FIG. 4 illustrates a waveform of the output signal OUT of the amplifier circuit 101.

In (A) to (D) of FIG. 4, a broken line extending horizontally and denoted by reference sign 0 indicates the ground voltage (0 V) or the reference current 0 A. In these figures, an upper side from the broken line is the positive electrode side, and a lower side is the negative electrode side.

In the first voltage follower 117 constituting the output stage, the gate of the N-type transistor Q3 functions as the input terminal connected to the first interconnect LI. Since parasitic gate capacitance is associated with the gate of the N-type transistor Q3, the parasitic capacitance is associated with the first interconnect L1, and the parasitic capacitance in the first interconnect L1 is connected to the first capacitor 210.

In the section tA, when the input voltage of the first voltage follower 117 rises from 0 V as illustrated in (C) of FIG. 4, the input current flows through the first voltage follower 117 as illustrated in (A) of FIG. 4. When transitioning from the section tA to the section tB, as illustrated in (C) of FIG. 4, a value of the input voltage of the first voltage follower 117 reaches a maximum value, a change amount of the input voltage becomes 0, and as illustrated in (A) of FIG. 4, the input current flowing through the first voltage follower 117 becomes 0 **A.**

In the section tB, the input voltage of the first voltage follower 117 starts to decrease from the maximum value as illustrated in (C) of FIG. 4. When the input voltage starts to decrease, as illustrated in (A) of FIG. 4, a negative (negative electrode side) input current starts to flow through the first voltage follower 117. A value of the negative input current becomes maximum when the value of the input voltage of the first voltage follower 117 reaches 0 V as illustrated in (C) of FIG. 4, that is, when the change amount of the input voltage becomes maximum.

When transitioning from the section tB to the section tC, the input voltage of the first voltage follower 117 is switched from a positive (positive electrode side) voltage to a negative (negative electrode side) voltage as illustrated in (C) of FIG. 4. At this time, parasitic capacitance associated with the input terminal of the first voltage follower 117 is discharged, causing a transient large current to flow as indicated by reference sign 410 in (A) of FIG. 4.

In Embodiment 1, this transient large current flows through the first capacitor 210 as illustrated in (B) of FIG. 4, and the first capacitor 210 is charged. Accordingly, the value of the drive current Ihs flowing through the first level shift circuit 111 can be prevented from fluctuating due to the transient large current, and can be maintained at a constant value.

By maintaining the value of the current flowing through the level shift circuit 111 constant, it is possible to prevent the level shift voltage shifted by the level shift circuit 111 from fluctuating, and the positive electrode side level shift signal Shs is stably output. As a result, as illustrated in (D) of FIG. 4, the output signal OUT of the amplifier circuit 101 becomes a signal with reduced distortion.

In the section tC to a section tD, the positive electrode side and the negative electrode side are switched, but a similar operation as in the section tA to the section tB is performed. After a section tE, a similar operation as in the sections tA to tD is repeated. From the section tC to the section tD, since a polarity is switched from that in the section tA to the section tB, when transitioning from the section tD to the section tE, the parasitic capacitance associated with the input terminal of the first voltage follower 117 is charged as illustrated in (A) of FIG. 4. At this time, as illustrated in (B) of FIG. 4, the first capacitor 210 is discharged to charge the parasitic capacitance.

By the series of operations, even when a transient large current flows to charge and discharge the parasitic capacitance associated with the first interconnect L1, the output signal OUT of the amplifier circuit 101 can be a low distortion signal. In (D) of FIG. 4, the positive electrode side of the output signal OUT is output from the first voltage follower 117, and the negative electrode side is output from the second voltage follower 118.

Although the parasitic capacitance associated with the input terminal of the first voltage follower 117 has been described as an example of the parasitic capacitance charged and discharged by the first capacitor 210, the parasitic capacitance charged and discharged by the first capacitor 210 is not limited thereto. That is, the first capacitor 210 charges and discharges not only the parasitic capacitance associated with the input terminal of the first voltage follower 117 but also parasitic capacitance associated with the first interconnect L1 to stabilize a current flowing through the first level shift circuit.

In order to reduce a transient large current generated by the parasitic capacitance associated with the first interconnect L1, the first capacitor 210 performs charging and discharging operations. The first capacitor 210 according to Embodiment 1 has a current supply capability capable of charging (charging and discharging) parasitic capacitance associated with the first interconnect L1. Since the first capacitor 210 is driven by the voltage amplifier circuit 110, the voltage amplifier circuit 110 has a current supply capability capable of charging (charging and discharging) the first capacitor 210. Accordingly, in Embodiment 1, it is possible to offset a transient large current by charging and discharging of the first capacitor 210.

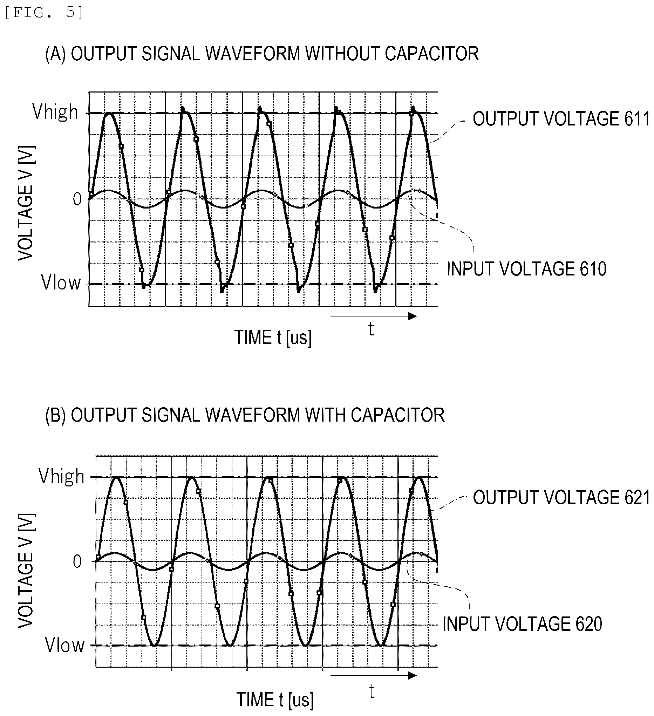

FIG. 5 is a waveform diagram illustrating output signals of the amplifier circuit according to Embodiment 1 and the amplifier circuit according to the comparative example. Here, (A) of FIG. 5 illustrates a waveform of the output signal of the amplifier circuit according to the comparative example described in FIG. 2, and (B) of FIG. 5 illustrates a waveform of the output signal of the amplifier circuit according to Embodiment 1.

In FIG. 5, reference signs 610 and 620 denote voltage waveforms of input signals input to the amplifier circuit, and reference signs 611 and 621 denote voltage waveforms of output signals output from the amplifier circuit.

As illustrated in (A) of FIG. 5, in the amplifier circuit according to the comparative example, distortion occurs in the vicinity where the output signal reaches a maximum value. In contrast, in the amplifier circuit according to Embodiment 1, fluctuation in a current supplied to the level shift circuit is reduced by charging (charging and discharging) of the capacitor connected to the level shift circuit, and as illustrated in (B) of FIG. 5, distortion is removed even when the output signal reaches a maximum value. That is, it is possible to obtain an output signal having a large amplitude by a push-pull operation while reducing the distortion of a signal waveform.

### <Reduction of Heat Generation and Size Increase>

Waveform distortion of the output signal generated by the transient large current can be addressed by the configuration of the first and second current source circuits 113 and 114 that supply the drive currents Ihs and Ils to the first and second level shift circuits. That is, by implementing the first and second current source circuits with a plurality of multi-stage unit current source circuits and increasing output impedance of the first and second current source circuits, it is possible to reduce an effect on the drive currents Ihs and Ils even when a transient large current occurs.

However, in order to increase the number of stages of the plurality of unit current source circuits, it is essential to increase voltages of the positive power supply 115 and the negative power supply 116 that supply power to the first and second current source circuits 113 and 114 implemented by the plurality of unit current source circuits to high voltages (high voltages in absolute value). When the voltages of the positive power supply 115 and the negative power supply 116 are increased, heat generated by the first and second voltage followers 117 and 118 increases, and a heat generation problem occurs. Since each of the first and second current source circuits is implemented by a plurality of unit current source circuits, the number of semiconductor devices constituting the first and second current source circuits increases, a size of the first and second current source circuits becomes large, which in turn increases the size of the amplifier circuit.

In the amplifier circuit according to Embodiment 1, since the waveform distortion of the output signal can be reduced by the first and second capacitors, even if the first and second current source circuits 113 and 114 are implemented by multi-staged unit current source circuits in addition to the first and second capacitors, it is possible to reduce the number of stages of the multi-stage unit current source circuits. Since the first and second capacitors are provided, a size increases accordingly, but the number of stages of the unit current source circuit can be reduced, making it possible to prevent an increase in size. In addition, since the number of stages can be reduced, it is possible to reduce an increase in voltage of the positive power supply 115 and the negative power supply 116, and to reduce heat generation.

In Embodiment 1, since the first and second level shift circuits are each implemented by the MOS transistor and the load resistor connected in series, the first and second level shift circuits can be implemented with a small number of elements, and an increase in size can be reduced.

### (Embodiment 2)

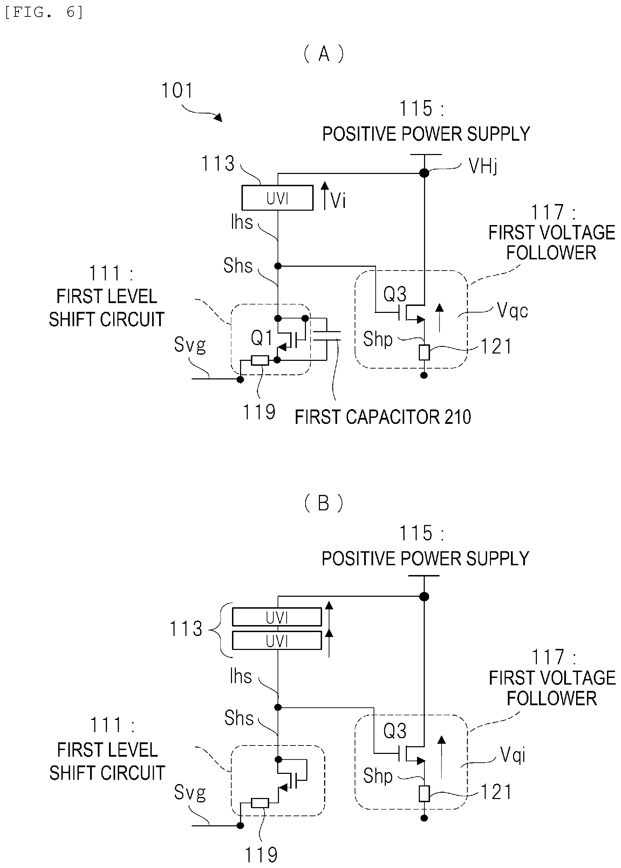

FIG. 6 is a circuit diagram illustrating an amplifier circuit according to Embodiment 2. Here, (A) of FIG. 6 is a circuit diagram illustrating a configuration of the amplifier circuit according to Embodiment 2. (B) of FIG. 6 is a circuit diagram illustrating a configuration of a comparison circuit for illustrating the amplifier circuit according to Embodiment 2.

(A) of FIG. 6 illustrates only a portion corresponding to a part (positive electrode side) of the amplifier circuit illustrated in FIG. 1. That is, in (A) of FIG. 6, only the portions corresponding to the first level shift circuit 111, the first current source circuit 113, and the first voltage follower 117 illustrated in FIG. 1 are illustrated, and the other portions are omitted, and a configuration on the negative electrode side is similar as that of (A) of FIG. 6 except that the transistor is replaced by the P-type transistor.

In Embodiment 2, the first current source circuit 113 is implemented by one unit current source circuit UVI. In (A) of FIG. 6, a voltage drop of the unit current source circuit UVI is indicated by reference sign Vi.

As in Embodiment 1, the first capacitor 210 is connected to the first level shift circuit 111. Accordingly, as described above, even when a transient large current flows, the first capacitor 210 charges and discharges, making it possible to reduce waveform distortion of an output signal. In other words, the transient large current is offset by the first capacitor 210.

Therefore, even if output impedance of the first current source circuit 113 is relatively low, it is possible to prevent a drive current supplied to the first level shift circuit 111 from fluctuating due to the transient large current.

The comparative example illustrated in (B) of FIG. 6 is similar to (A) of FIG. 6. A difference is that, in (B) of FIG. 6, the first capacitor is not provided, and the first current source circuit 113 has a configuration in which two unit current source circuits UVI are provided in multiple stages.

The unit current source circuit UVI illustrated in (B) of FIG. 6 is the same as that illustrated in (A) of FIG. 6. In (B) of FIG. 6, by implementing the unit current source circuits UVI in multiple stages, the drive current Ihs supplied to the first level shift circuit 111 has the same value as the drive current Ihs in (A) of FIG. 6, but the output impedance of the first current source circuit 113 can be increased. Accordingly, in the comparative example illustrated in (B) of FIG. 6 as well, even when a large current transiently flows, it is possible to reduce the fluctuation of the drive current supplied to the first level shift circuit and reduce the waveform distortion of the output signal.

However, in order to make a voltage of the signal Shp output by the first voltage follower 117 the same value in (A) and (B) of FIG. 6, a voltage of the positive power supply 115 differs between (A) and (B) of FIG. 6.

That is, in (A) of FIG. 6, a positive voltage of the positive power supply 115 is VHj, and a voltage Vqc is applied between the source and the drain of the N-type transistor Q3 constituting the first voltage follower 117 in order to set the signal Shp to a predetermined voltage value.

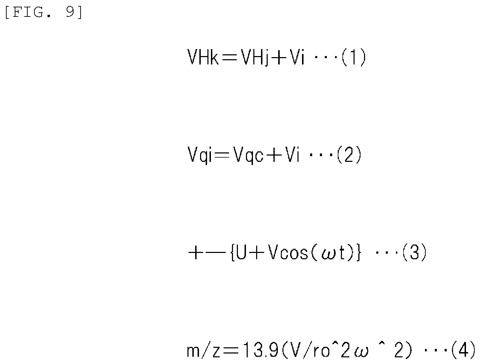

In contrast, in the configuration of (B) of FIG. 6, in order to obtain the signal Shp having the same predetermined voltage value, since the first current source circuit 113 is implemented by the two-stage unit current source circuits UVI, the voltage drop in the first current source circuit 113 becomes twice the voltage drop Vi, and a positive voltage VHk of the positive power supply in (B) of FIG. 6 becomes a value represented by formula (1) illustrated in FIG. 9. Therefore, in the configuration of (B) of FIG. 6, a voltage Vqi obtained by formula (2) illustrated in FIG. 9 is applied between the source and the drain of the N-type transistor Q3 constituting the first voltage follower 117. That is, when the first current source circuit 113 is implemented by multi-stage unit current source circuits, it is necessary to operate the amplifier circuit at a high voltage, a voltage applied to the first voltage follower 117 increases, power consumption increases, and the increased power consumption causes the circuit to generate heat.

Since there is a risk that a temperature of the semiconductor device exceeds a rating of the semiconductor device due to heat generation, a heat sink or a cooling fan may be used to reduce heat generation, but mounting of such a cooling mechanism is not desirable because it directly leads to an increase in a circuit size and an increase in manufacturing cost.

According to Embodiment 2, by one unit current source circuit and the first and second capacitors, the waveform distortion of the output signal can be prevented, and an increase in size and heat generation can be reduced.

### (Embodiment 3)

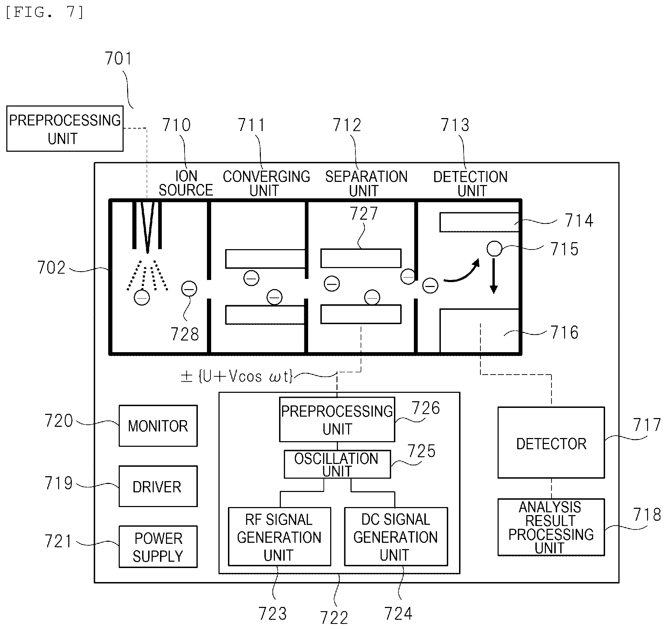

In Embodiment 3, a mass spectrometer including the amplifier circuit described in Embodiment 1 will be described. FIG. 7 is a block diagram illustrating a configuration of the mass spectrometer according to Embodiment 3. In FIG. 7, reference sign 701 denotes the mass spectrometer.

The mass spectrometer 701 includes a measurement unit 702 including an ion source 710 that ionizes a sample as an analysis target sent from a preprocessing unit, a converging unit 711 that converges an ionized analysis sample 728, a separation unit 712 that filters the converged ions according to a mass-to-charge ratio and passes only the ionized sample as a detection target, and a detection unit 713 that causes the passed ionized sample to collide with a conversion dynode 714, changes the ionized sample to electrons 715, causes the electrons to be incident on a scintillator 716, and outputs photons according to an amount of electrons. The mass spectrometer 701 further includes a detector 717 that outputs an electrical signal corresponding to photons output from the detection unit 713, an analysis result processing unit 718 that processes the electrical signal output from the detector 717, a driver 719 that drives the measurement unit 702, a monitor 720 that monitors the measurement unit 702, a power supply 721 that supplies power to each part, and a control unit 722 that controls mass spectrometry.

The control unit 722 includes an RF signal generation unit 723 that generates an AC signal, a DC signal generation unit 724 that generates a DC signal, an oscillation unit 725 that boosts an input signal by a resonance circuit and outputs the boosted signal, and a preprocessing unit 726 that processes the signal input from the oscillation unit 725 and outputs the processed signal to an MS filter 727 in the separation unit 712.

Next, an operation until the ionized analysis sample 728 reaches the detection unit 713 will be described with reference to FIG. 7.

The MS filter 727 in the separation unit 712 includes four electrodes, and a voltage obtained by superimposing a DC voltage U and an AC voltage Vcos(ωt) is applied to the opposing electrodes having the same polarity. A value of the applied voltage is expressed by formula (3) illustrated in FIG. 9. The MS filter 727 forms an electric field corresponding to the voltage expressed by formula (3). In formula (3), ω = 2πf, f represents a frequency of the AC voltage, and V represents a maximum value of the AC voltage.

When the ionized analysis sample 728 is incident on the electric field formed by the MS filter 727 of the separation unit 712, the ionized analysis sample 728 moves toward the detection unit 713 while vibrating up and down and left and right. At this time, with respect to a voltage value applied to the MS filter 727, only ions having a specific mass spectrometry ratio m/z perform a stable amplitude motion, pass through the MS filter 727, and reach the detection unit 713. Meanwhile, ions having other mass spectrometry ratios m/z have a large amplitude and diverge, resulting in collision with the electrode. Accordingly, only the ions having the target mass spectrometry ratio m/z reach the detection unit 713.

The mass spectrometry ratio m/z of ions measured by the mass spectrometer 701 is set by the magnitude V of the AC voltage applied to the MS filter 727, a frequency ω thereof, and a distance 2ro between the electrodes of the MS filter 727, and the mass spectrometry ratio m/z is expressed by formula (4) illustrated in FIG. **9****.** In formula (4), ^2 represents a square.

From formula (4) of the mass spectrometry ratio m/z, it is conceivable to increase the value V of the AC voltage and decrease values of the distance ro and the frequency ω in order to analyze ions having a large mass. However, due to a structure of the actual mass spectrometer 701, the distance ro cannot be set to several mm or less, and if the frequency ω is too small, ions cannot vibrate sufficiently. Therefore, it is possible to expand a measurement range of ions and to analyze ions having a large mass by increasing the value V of the AC voltage. Resolution of the mass spectrometer 701 depends on assembly accuracy of the electrode of the MS filter 727, processing accuracy of an electrode surface, stability of a value of the DC voltage U and the value V of the AC voltage, and the frequency ω of the AC voltage. The frequency ω determines the number of vibrations when ions pass through the MS filter 727, and since high resolution is obtained when the number of vibrations is large, the higher the frequency ω and the longer the electrode of the MS filter 727, the higher the resolution of the device. From these factors, in order to expand a measurement range and improve the resolution of the mass spectrometer 701, a voltage applied to the MS filter 727 is required to be a high voltage and a high frequency.

As illustrated in FIG. 7, in the MS filter 727, an AC signal output from the RF signal generation unit 723 is boosted by the oscillation unit 725 and then applied to the MS filter 727 via the preprocessing unit 726. Since the signal applied to the MS filter 727 requires high frequency stability, an LC circuit that achieves a high Q value is used in the oscillation unit 725. However, in order to achieve both high voltage and high frequency in this LC circuit, it is essential to increase a drive current from the RF signal generation unit 723.

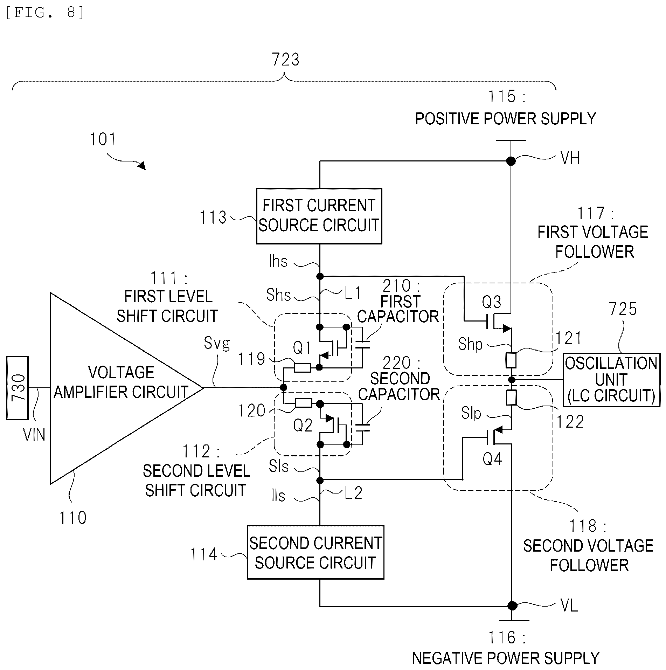

FIG. 8 is a circuit diagram illustrating a configuration of the RF signal generation unit according to Embodiment **3.** FIG. 8 illustrates a specific example of the RF signal generation unit 723 illustrated in FIG. 7 and the oscillation unit 725 to which a signal from the RF signal generation unit 723 is supplied.

The RF signal generation unit 723 includes a generation unit 730 that generates an RF signal and the amplifier circuit. In FIG. 8, the amplifier circuit 101 illustrated in FIG. 1 is used as the amplifier circuit.

Since the configuration, operation, and the like of the amplifier circuit 101 have already been described in Embodiment 1, detailed description thereof will be omitted. The generation unit 730 generates an AC signal whose voltage periodically changes. The AC signal is input to the amplifier circuit 101 as the input signal VIN. The output terminal of the amplifier circuit 101 is connected to the LC circuit constituting the oscillation unit 725. Accordingly, the AC signal, which is an output signal output from the amplifier circuit 101, is supplied to the LC circuit, is supplied to the preprocessing unit 726 via the LC circuit, and is further supplied to the electrode of the separation unit 712.

As understood from FIG. 8, the first capacitor 210 and the load resistor 119 are connected in series between the first interconnect L1 and the output terminal of the voltage amplifier circuit 110. Therefore, it can be considered that the first capacitor 210 and the load resistor 119 constitute a filter (hereinafter, also referred to as a first filter). Similarly, it can be considered that the second capacitor 220 and the load resistor 120 constitute a filter (hereinafter, also referred to as a second filter).

In Embodiment 3, values of the first capacitor 210, the second capacitor 220, and the load resistors 119 and 120 are set such that cutoff frequencies of the first filter and the second filter are higher than a resonance frequency of the separation unit 712. More specifically, the values of the capacitor and the load resistor are set such that the cutoff frequencies of the first filter and the second filter are higher than the resonance frequency of the MS filter 727 of the separation unit 712 (FIG. 7).

Accordingly, the AC signal amplified by the amplifier circuit 101 and having a high drive current can be supplied to the oscillation unit 725 while reducing an increase in size and heat generation. By setting the AC signal supplied to the oscillation unit 725 to a high drive current, a voltage applied to the MS filter 727 can be increased. In the amplifier circuit 101, since the distortion of the waveform can be prevented and the cutoff frequencies of the first filter and the second filter are higher than the resonance frequency of the MS filter, the output signal from the voltage amplifier circuit 110 can be transmitted to the MS filter 727 without being distorted.

That is, a high voltage and high frequency of a voltage applied to the MS filter 727 can be achieved, making it possible to expand the measurement range of the mass spectrometer 701 and improve resolution without increasing a size of the mass spectrometer or increasing heat generation.

The amplifier circuit 101 described in Embodiments 1 to 3 may be formed in one semiconductor chip, or may be implemented by combining a plurality of discrete semiconductor devices.

Although the voltage follower has been described as an example in Embodiments 1 to 3, the invention is not limited to the voltage follower. That is, a current amplifier circuit that amplifies a current may be used instead of the voltage follower.

Although the invention made by the present inventors has been specifically described based on the embodiment, the invention is not limited to the embodiment, and it is needless to say that various modifications can be made without departing from the gist of the invention.

### Reference Signs List

101, 301: amplifier circuit
119, 120, 121, 122: load resistor
L1: first interconnect
L2: second interconnect
Q1, Q3: N-type transistor
Q2, Q4: P-type transistor
UVI: unit current source circuit

## Claims

1. An amplifier circuit for outputting an output signal corresponding to an input signal, the amplifier circuit comprising:
a first current source circuit configured to output a predetermined current amount to a first interconnect;
a voltage amplifier circuit configured to amplify a voltage of the input signal;
a first level shift circuit connected between the first interconnect and an output of the voltage amplifier circuit and configured to shift a voltage of a signal output from the voltage amplifier circuit;
a first voltage follower connected to the first interconnect and configured to amplify a signal in the first interconnect; and
a first capacitor connected between the first interconnect and the output of the voltage amplifier circuit.

2. The amplifier circuit according to claim 1, wherein
the first capacitor has a current supply capability for charging parasitic capacitance that is parasitic on the first interconnect, and
the voltage amplifier circuit has a current supply capability for charging the first capacitor.

3. The amplifier circuit according to claim 1, wherein
the first level shift circuit includes a resistance element and a voltage element which are connected in series between the first interconnect and the output of the voltage amplifier circuit, and
the first capacitor is connected in parallel with the voltage element.

4. The amplifier circuit according to claim 1, further comprising:
a second current source circuit configured to output a predetermined current amount to a second interconnect different from the first interconnect;
a second level shift circuit connected between the second interconnect and the output of the voltage amplifier circuit and configured to shift a voltage of a signal output from the voltage amplifier circuit;
a second voltage follower connected to the second interconnect and configured to amplify a signal in the second interconnect; and
a second capacitor connected between the second interconnect and the output of the voltage amplifier circuit, wherein
an output of the first voltage follower and an output of the second voltage follower are combined and output as the output signal.

5. A mass spectrometer comprising:
the amplifier circuit according to claim 3; and
a separation unit configured to pass only an ionized sample as a detection target, wherein
a capacitance value of the first capacitor is set such that a cutoff frequency defined by the resistance element and the first capacitor is higher than a resonance frequency of the separation unit.
